# EUROPEAN PATENT SPECIFICATION

(11) **EP 0 693 711 B1**
(45) Date of publication and mention of the grant of the patent: **15.03.2000**
(21) Application number: 95201755.6
(22) Date of filing: 28.06.1995
(51) Int. Cl.: G03F 7/34, B29C 63/00

(54) **Initiating the delamination of an image suited for dry processing**
Starten der Delaminierung eines für Trockenbehandlung geeigneten Bildes
Initiation de la délamination d'une image adaptée au traitement à sec

(30) Priority: 18.07.1994 BE 9400672
(43) Date of publication of application: 24.01.1996
(73) Proprietor: AGFA-GEVAERT N.V., 2640 Mortsel (BE)
(72) Inventor: De Niel, Marc, c/o Agfa-Gevaert N.V., B-2640 Mortsel (BE); De Kegelaer, Martin, c/o Agfa-Gevaert N.V., B-2640 Mortsel (BE)

(56) References cited:
- GB-A- 2 008 028
- PATENT ABSTRACTS OF JAPAN vol. 11 no. 211 (P-594) ,9 July 1987 & JP-A-62 031850 (NITTO ELECTRIC CO. LTD.) 10 February 1987,

## Description

### BACKGROUND OF THE INVENTION

### Field of the invention

The present invention relates to a device for producing an imaging element by peeling apart an image-receiving base and an imaging-layer bearing base laminated thereto subsequent to the imagewise exposure of said imaging layer, e.g. by means of laser radiation.

### Description of the prior art

Several proposals have been disclosed so far for obtaining an imaging element suited for development according to dry process steps with the main purpose of avoiding the use of any processing liquid.

In addition to the substantial ecological advantages of dry processing, the image carrier by itself offers the considerable benefit of being suited for processing under regular room illumination. However, these features are counterbalanced by the relatively low sensitivity and the high-power exposing equipment involved.

The latent-image formation commonly occurs by introducing selective adhesion differences between the density-producing and the image-bearing layers by means of an imagewise heat treatment. The processing, or visible-image formation, may be performed by a sequential laminating-delaminating step of a sheet material against the image-bearing-surface of a recorded film. The imaging material, as described e.g. in patent application EP-A-0 705 173, generally comprises a transparent base bearing an imaging layer. The imaging layer is covered with a release layer and a thermosensitive adhesive layer having a second-order transition temperature ranging from 20 to 60 °C.

The processing occurs by laminating a transfer sheet material to the thermosensitive adhesive layer under pressure and at increased temperature. Such transfer sheet material may be any coated or uncoated paper type, polyester or any other flat base. The visible image is produced by peeling apart again the laminate of the two above-mentioned sheet materials, i.e. the image-bearing and the transfer sheet materials. During the peeling-apart or delamination process the imagewise recorded areas of the imaging and release layers are left on the transparent base. The non-image areas, i.e. the layer areas that have not been imagewise recorded, together with the release layer remain adhered to the transfer sheet material. As a result of the peeling-apart process two complementary images are generated, i.e. one on the transparent base and the other on the transfer sheet material.

For several reasons :
1. the highest possible production speed,
2. speed range for allowing lamination and delamination to take place at the same speed,
3. speed range for obtaining an optimum image quality irrespective of the material applied,
it is essential to apply a sufficiently high amount of heat to the sheet materials within a relatively short period of time. This can be realised by exposing the transfer sheet material and/or film either for a short time to a rather high temperature or for a prolonged time to a lower temperature. A sufficient heat supply to the thermosensitive adhesive layer is required for heating it to above its second-order transition temperature so that it softens and exhibits its adhesive behaviour.

For the same reasons, the initiation or start of delamination and the actual delamination or peeling-apart of the two sheet materials at the delamination side should occur at the highest possible speed. However, there are following restrictions :
1. at its bottom side speed is restricted by the specified minimum production speed and the speed-dependent image quality,
2. at its top side speed is restricted by the possibilities of accelerating from standstill or low speed to that high speed.

Practical values are as follows :
- initiation speeds ranging from 1 to 20 m/min
- delamination speeds varying between 1 and 10 m/min.

Devices for realising the peeling apart of two bases laminated together have been disclosed in Patent Application EP-A-0 654 347.

### OBJECT OF THE INVENTION

It is an object of the present invention to provide an improved device for initiating the peeling apart of such laminated bases.

### SUMMARY OF THE INVENTION

According to the present invention a device for initiating the delamination of two bases laminated together arranged for forming a practicable image in one of the bases is characterised in that one of the bases with leader is laminated to the other, means are provided for positioning the laminate and clamping same in one particular position leaving leading edges of the laminate free, means are provided for bending off the free leading edges of the laminate on a well-specified corner, causing thereby an initiation of the delamination, and for scraping the base without leader from the other base, and means are provided for clamping the scraped-off base.

According to one embodiment the device of the present invention is characterised in that the laminate is clamped between a basic element and a supporting element, leaving the leading edges of the laminate free, and the base with leader is contacting the supporting element secured to the basic element by means of a moving L-shaped separating element, which in its initial state is retracted under the leader and free leading edges, which when shifted to a second state bends the free leading edges and leader off on a corner of the supporting element, leaving thereby the leader clamped between the separating element and the supporting element and releasing thereby the leading edge of the other base resulting in an initiation of the delamination, which when returning to its initial position is scraping the base without leader from the other base and is clamping the scraped-off base between separating and basic elements.

According to a further embodiment the device of the present invention is characterised in that the basic element consists of a drum with a specified radius on which one of the bases is guided during further lamination.

The present invention as described herein is particularly related to producing a visible image by means of a laminating-delaminating process as described above. It will be clear to those skilled in the art that a device in accordance with the present invention is not limited to this particular application but can also serve for producing printing plates, proofing material, etc., by delaminating a previously laminated image-receiving base.

### BRIEF DESCRIPTION OF THE DRAWINGS

The present invention is described hereinbelow by way of illustration referring to the enclosed diagrams of some embodiments wherein :
Fig. 1a to 1d represent a first embodiment of a device for initiating the delamination of two bases laminated together,
Fig. 2 represents a second embodiment,
Fig. 3 represents a third embodiment,
Fig. 4a to 4e represent the various steps of a fourth embodiment,
Fig. 5 represents alternative designs of the scraping and clamping systems,
Fig. 6 represents an alternative design of scraping system and basic element.

### DETAILED DESCRIPTION OF THE INVENTION

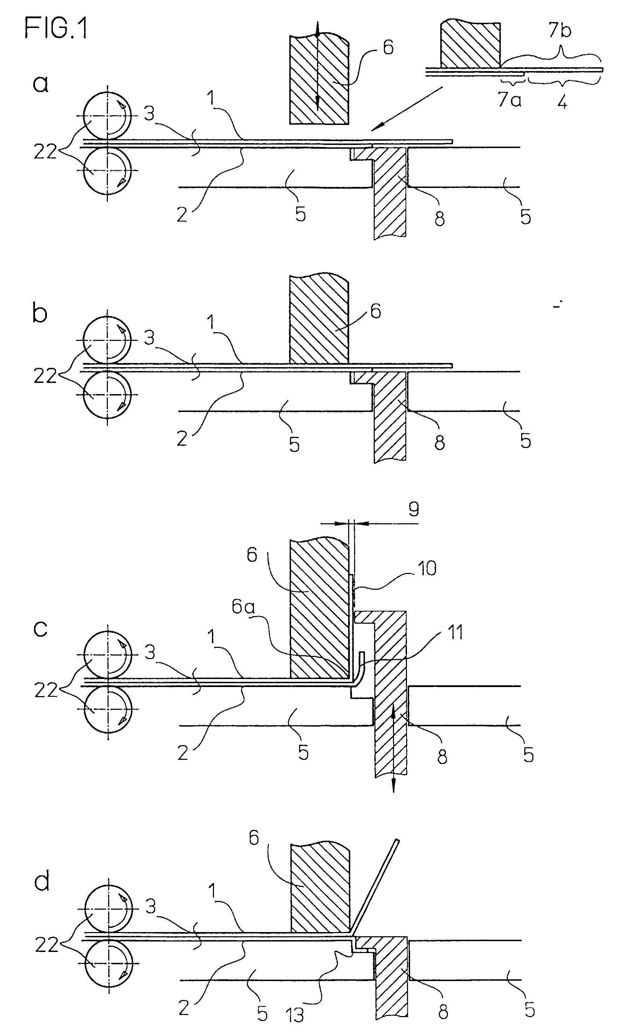

Fig. 1 is a diagram of a device for initiating the peeling apart of two sheet materials resp. 1 and 2 constituting together a laminate 3 and being laminated together in such a way that one of the sheet materials comprises a leader 4.
The device consists of a basic element 5 onto which a supporting element 6 can be clamped, and a generally L-shaped separating element 8, flexibly mounted on the basic element, which in its initial state or idle state is lying recessed within the basic element.

The laminate is positioned and clamped (Fig. 1b) between the basic element 5 and a supporting element 6 in a way that free leading edges 7a and 7b of a well-specified length are still present and that the base 2 without leader is adjacent to the basic element 5.

Wenn the L-shaped separating element 8 is shifted to a second position by being pushed out of the basic element 5 at a specified speed, the free leading edges 7a and 7b are bent off on a corner 6a of the supporting element. Due to the difference in stiffness together with a combination of tensile force, speed, and corner radius, the above-mentioned bending-off on a corner results in an outward force component that exceeds the bond strength between sheet materials 1 and 2. The device is designed in a way that, when the separating element (Fig. 1c) is in its second position, end 10 of the base with leader 1 is clamped between separating element 8 and supporting element 6, whereas end 11 of the other base is released so that in combination with the outward force an initiation of the delamination is produced.
Upon return of the L-shaped separating element (Fig. 1d) to its initial or idle state, the special L-shape makes that the released end 11 of base 2 without leader is scraped off from the other base 1 and eventually becomes clamped between separating element 8 and basic element 5.
Both the degree of bending-off of the free leading edges 7a and 7b when the separating element 8 is being shifted to its second position, and the clamping of the base with leader 1 in this second position are defined by the spacing 9 between the separating element 8 and the supporting element 6 (Fig. 1c).

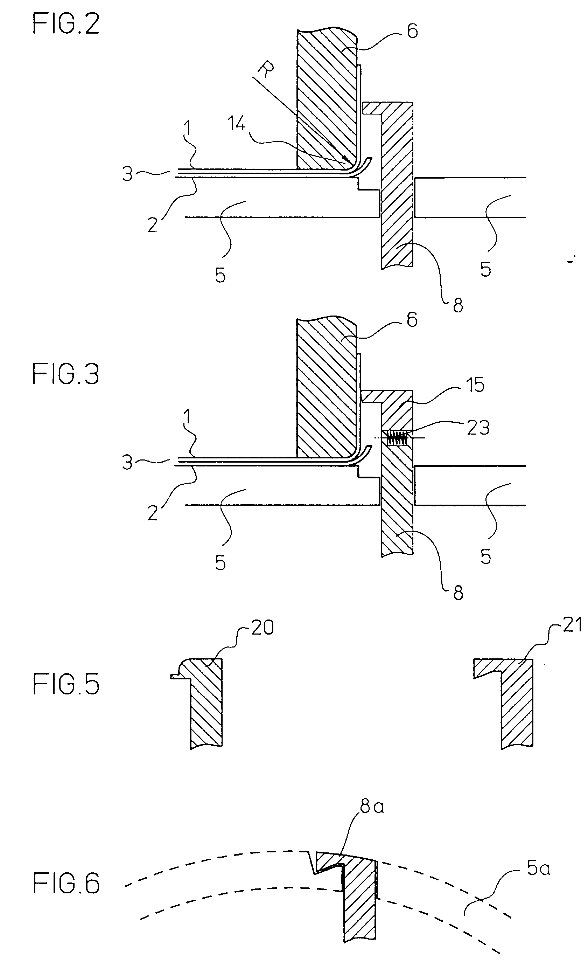

Fig. 2 is a diagram of another embodiment of a device for initiating the peeling-apart process of a laminate 3. The initiation and clamping proceeds in a similar way as in the above-described embodiment with the difference, however, that the corner of supporting element 6 on which the free leading edges of laminate 3 are bent off is rounded at a specified radius 14.

Fig. 3 is a diagram of still another embodiment wherein nose 15 of the L-shaped element 8 is spring-mounted 23 obtaining thereby always the same pressure between free leading edges 7a, 7b and leader 4 on one hand, and supporting element 6 on the other hand.

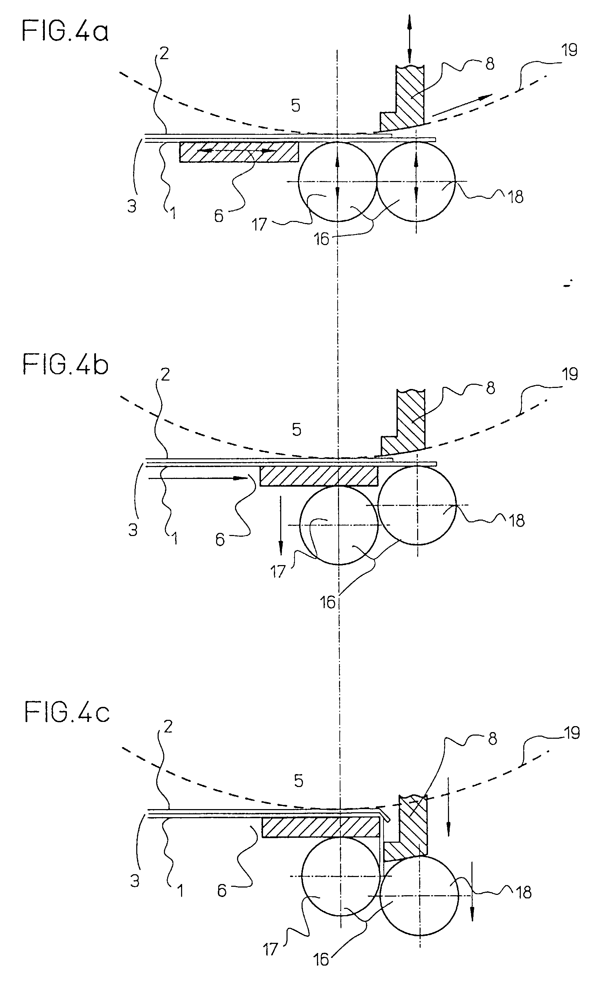

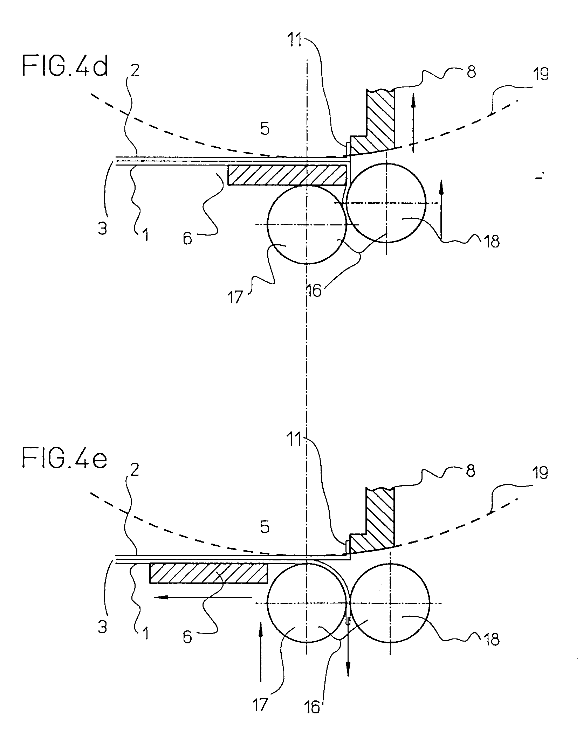

Fig. 4 is a diagram of still a further embodiment of a device for initiating the peeling apart of 2 bases resp. 1 and 2 wherein the basic element 5 is integral with a roller or drum 19 the diameter of which is selected in a way that said roller can also serve as one of two rolls on which delamination is carried out (as per our pending patent application BE-A-1 008 502). The device is designed in a way that the L-shaped element 8 is recessed within basic roller 19. Furthermore, the device provides a roller pair 16 and a supporting element 6. The roller pair 16 is spring-mounted and presses against basic roller 5. After the initiation one of the two rollers of roller pair 16 serves as delamination roll 17 which is mounted in a way that his movement is only possible along the centre line that is also extending through basic roller 5. The remaining roller 18 of the roller pair is spring-mounted in a way that its circumference always follows the circumference of delamination roll 17 and that it is pressed on always in the direction of the basic roller. The supporting element 6 can only move in the direction as indicated.

Fig. 4a represents the initial state of the device for initiating the peeling apart of two laminated bases. Laminate 3 is positioned between basic roller 19 and roller pair 16.

Fig. 4b represents a second state wherein supporting element 6 is slid under roller 17 of the roller pair as a result of which laminate 3 is clamped between basic roller 19 and supporting element 6.

Fig. 4c represents a following state reached by the device and wherein the L-shaped separating element 8 is shifted to a second position resulting in an initiation of the delamination similar to the arrangement in Fig. 1. In this particular state the end of base with leader 1 is situated near the contact surface of both rollers of roller pair 16.

Fig. 4d represents a following state of the device. The L-shaped separating element 8 returned to its initial state, and, for reaching this state, it has further scraped off and clamped the released end 11 of the base without leader from the other base. Due to this movement of separating element 8 and the corresponding movement of roller 18 of the roller pair the base with leader is clamped between the contact surfaces of the roller pair 16.

Fig. 4e represents again the initial state of the device. Supporting element 6 again returned to its idle state, wherein the base with leader is clamped between the contact surfaces of roller pair 16, and the base without leader is clamped between the L-shaped separating element 8 and the basic roller 19. Further delamination can now occur, wherein the point of delamination is situated on the contact surface of basic roller 19 and roller 17 of the roller pair.

Fig. 5 represents some alternatives 20 and 21 of the design of L-shaped separating element 8, wherein the design of the separating element is such that the scraping-off process of the base from the laminate is optimized.

Fig. 6 represents such a design of the basic element 5, wherein in the intitial state and in the state in which one of the bases is clamped between L-shaped separating element 8 and basic element 5, the separating element follows the surface of the basic element. This particular design can also be applied when the basic element 5 is a roller 19, as a result of which during delamination of a laminate the length of which exceeds the circumference of the basic roller said initiating device forms no obstruction if a path longer than the circumference of the basic roller 19 is followed.

It will be clear to those skilled in the art that, depending on the imaging material applied, other designs and sizes for the various elements may be used.

## Claims

1. A device for initiating the delamination of a first sheet (1) from a second sheet (2), the two sheets (1, 2) being laminated together such that a leading edge (7b) of the first sheet (1) extends beyond a leading edge (7a) of the second sheet (2), the device comprising:
- a base element (5);
- a supporting element (6) for clamping the two sheets against the base element (5) such that the leading edges (7a, 7b) of the two sheets are left free;
- a separating element (8) for bending the leading edges (7a, 7b) of the two sheets around a corner (6a) of the supporting element (6);
characterised in that the separating element (8) is provided with means for scraping the second sheet (2) off the first sheet (1), and means for clamping the leading edge (7a) of the second sheet (2) against the base element (5).

2. The device according to claim 1, wherein the separating element (8) is an L-shaped element, slidably mounted to the base element (5), initially being recessed within the base element (5), comprising:
- means for initiating the delamination of the two sheets by sliding out of the base element (5), thereby causing the leading edges (7a, 7b) of the sheets to bend around the corner (6a) of the supporting element (6),
- means for clamping the leading edge (7b) of the first sheet (1) against the supporting element (6).

3. The device according to claim 2, wherein the corner (6a) of the supporting element (6) is arcuate (14).

4. The device according to any one of claims 2 to 3, wherein the separating element (8) has a nose (15) that is spring-mounted (23), for causing during bending a constant pressure between the leading edge (7b) of the first sheet (1) and the supporting element (6).

5. The device according to any one of the preceding claims, wherein the base element (5) is an arcuate drum (19), for transporting the second sheet (2) during further delamination.

6. The device according to the preceding claim, further having a roller pair (16), for transporting the first sheet (1) during further delamination, after the initiation of the delamination.

## Patentansprüche

1. Ein Gerät zum Starten der Delaminierung eines ersten Bogens (1) von einem zweiten Bogen (2), wobei die zwei Bogen (1) und (2) derart übereinander laminiert sind, daß sich ein Vorderrand (7b) des ersten Bogens (1) hinter einen Vorderrand (7a) des zweiten Bogens (2) erstreckt, wobei das Gerät folgendes umfaßt :
- ein Basiselement (5),
- ein Stützelement (6), das die zwei Bogen derart gegen das Basiselement (5) klemmt, daß die Vorderränder (7a) und (7b) der zwei Bogen frei gelassen werden,
- ein Trennelement (8), das die Vorderränder (7a) und (7b) der zwei Bogen um eine Ecke (6a) des Stützelements (6) biegt,
dadurch gekennzeichnet, daß das Trennelement (8) mit einem Mittel, das den zweiten Bogen (2) vom ersten Bogen (1) ablöst, und einem Mittel, das den Vorderrand (7a) des zweiten Bogens (2) gegen das Basiselement (5) klemmt, versehen ist.

2. Gerät nach Anspruch 1, dadurch gekennzeichnet, daß das Trennelement (8) ein L-förmiges Element ist, das gleitend auf dem Basiselement (5) angeordnet ist und am Anfang versenkt innerhalb des Basiselements (5) vorliegt, und folgendes umfaßt :
- ein Mittel zum Starten der Delaminierung der zwei Bogen, wobei Trennelement (8) aus dem Basiselement (5) herausgezogen wird und dabei die Vorderränder (7a) und (7b) der Bogen um die Ecke (6a) des Stützelements (6) biegt,
- ein Mittel, das den Vorderrand (7b) des ersten Bogens (1) gegen das Stützelement (6) klemmt.

3. Gerät nach Anspruch 2, dadurch gekennzeichnet, daß die Ecke (6a) des Stützelements (6) bogenförmig (14) ist.

4. Gerät nach irgendeinem der Ansprüche 2 bis 3, dadurch gekennzeichnet, daß das Trennelement (8) eine Nase (15) hat, die mit Federn (23) angeordnet ist, damit während des Biegevorgangs zwischen dem Vorderrand (7b) des ersten Bogens (1) und dem Stützelement (6) ein konstanter Druck aufrechterhalten wird.

5. Gerät nach irgendeinem der vorstehenden Ansprüche, dadurch gekennzeichnet, daß das Basiselement (5) eine bogenförmige Trommel (19) ist, die den zweiten Bogen (2) während der weiteren Delaminierung befördert.

6. Gerät nach Anspruch 5, das ferner ein Walzenpaar (16), das den ersten Bogen (1) während der weiteren Delaminierung nach dem Starten der Delaminierung befördert, umfaßt.

## Revendications

1. Dispositif pour amorcer le décollement d'une première feuille (1) d'une deuxième feuille (2), les deux feuilles étant stratifiées de telle manière qu'un bord avant (7b) de la première feuille (1) dépasse un bord avant (7a) de la deuxième feuille (2), ledit dispositif comprenant :
- un élément de base (5),
- un élément d'appui (6) servant à serrer les deux feuilles contre l'élément de base (5) de telle manière que les bords avant (7a, 7b) des deux feuilles restent dégagés,
- un élément de séparation (8) servant à cintrer les bords avant (7a, 7b) des deux feuilles autour d'un coin (6a) de l'élément d'appui (6),
caractérisé en ce que l'élément de séparation (8) est muni de moyens pour séparer la deuxième feuille (2) de la première feuille (1) par grattage, et de moyens pour serrer le bord avant (7a) de la deuxième feuille (2) contre l'élément de base (5).

2. Dispositif selon la revendication 1, caractérisé en ce que l'élément de séparation (8) est un élément en forme de L, l'assemblage entre l'élément de séparation (8)et l'élément de base (5) étant mobile permettant le glissement, l'élément de séparation (8) étant initialement retracté dans l'élément de base et comprenant :
- des moyens pour amorcer le décollement des deux feuilles par leur sortie de l'élément de base (5) tout en glissant, ce qui provoque le cintrage des bords avant (7a, 7b) des feuilles autour du coin (6a) de l'élément d'appui (6),
- des moyens pour serrer le bord avant (7b) de la première feuille (1) contre l'élément d'appui (6).

3. Dispositif selon la revendication 2, caractérisé en ce que le coin (6a) de l'élément d'appui (6) est arqué (14).

4. Dispositif selon l'une quelconque des revendications 2 et 3, caractérisé en ce que l'élément de séparation (8) possède un bec (15) fixé à ressorts (23) pour provoquer une pression constante entre le bord avant (7b) de la première feuille (1) et l'élément d'appui (6) pendant le cintrage.

5. Dispositif selon l'une quelconque des revendications précédentes, caractérisé en ce que l'élément de base (5) est un tambour arqué (19) servant à transporter la deuxième feuille (2) pendant la suite du décollement.

6. Dispositif selon la revendication précédente, muni également d'une paire de rouleaux (16) servant à transporter la première feuille (1) pendant la suite du décollement, après l'amorçage du décollement.
